# EUROPEAN PATENT APPLICATION

(11) **EP 4 633 312 A1**
(43) Date of publication of application: **15.10.2025**
(21) Application number: 25165172.5
(22) Date of filing: 20.03.2025
(51) Int. Cl.: H05K 7/20

(54) **HYBRID AIR/LIQUID COOLING UNIT**

(30) Priority: 21.03.2024 US 202463568297 P; 11.02.2025 US 202563757025 P; 06.03.2025 US 202519072683
(71) Applicant: Vertiv Corporation, Westerville, OH 43082 (US)
(72) Inventor: BLASER, Colin L., Westerville (US); GUTIERREZ, John D., Westerville (US); MADARA, Steve M., Westerville (US); SCHUTTE, Daniel J., Westerville (US); RAVEN, Matthew A., Westerville (US); CRUZ, Javier, Westerville (US); BORROR, Steven A., Westerville (US); BREUER, Thomas C., Westerville (US); MILLER, Oliver M., Westerville (US); NEBRASKA, Jack T., Westerville (US); KING, Jeremy R., Westerville (US)
(74) Representative: Beal, James Michael

(57) **Abstract**

A cooling system may include a refrigerant circuit. A cooling system may include an air cooling circuit in fluid communication with the refrigerant circuit, the air cooling circuit including at least one first heat exchanger. A cooling system may include a liquid cooling circuit in fluid communication with the refrigerant circuit, the liquid cooling circuit including at least one second heat exchanger and at least one pump. A cooling system may include a valve assembly configured to selectively flow refrigerant to at least one of the air cooling circuit and the liquid cooling circuit. A cooling system may include a controller communicatively coupled to the valve assembly, the controller including one or more processors configured to control a flow of the refrigerant selectively to the at least one first heat exchanger or the at least one second heat exchanger.

## Description

### CROSS-REFERENCE TO RELATED APPLICATIONS

The present application claims the benefit of U.S. Provisional Patent Application Serial Number 63/568,297, filed March 21, 2024, and entitled HYBRID AIR/LIQUID COOLING UNIT, and U.S. Provisional Patent Application Serial Number 63/757,025, filed February 11, 2025, and entitled HYBRID AIR/LIQUID COOLING SYSTEM WITH INTERNAL TEMPERATURE CONTROL, and U.S. Non-Provisional Patent Application Serial Number 19/072,683, filed 6 March 2025, and entitled HYBRID AIR/LIQUID COOLING UNIT.

### TECHNICAL FIELD

The present disclosure relates to cooling systems for electronic equipment, and more particularly, to cooling systems for electronic equipment that are capable of using both air cooling and liquid cooling technologies.

### BACKGROUND

Telecommunication and computing industries rely on cooling systems to keep temperature-sensitive equipment (e.g., servers, computers) operating under rated or normal environmental conditions.

While the first cooling systems were based on heat exchangers that relied on airflow, newer systems often utilize liquid cooling systems for heat transfer. Many companies are looking to update legacy air cooling systems with liquid cooling. However, transitioning from air cooling systems to liquid cooling systems currently requires the purchase and installation of a separate cooling infrastructure, which can be prohibitively expensive, time-consuming, and require changes to be made to the building infrastructure. Accordingly, it may be advantageous to have a system that enables cooling systems to switch over from air cooling to liquid cooling without the aforementioned expense and time inputs.

### SUMMARY

In one or more embodiments, a cooling system is disclosed. In embodiments, the cooling system includes a refrigerant circuit; an air cooling circuit in fluid communication with the refrigerant circuit, the air cooling circuit including at least one first heat exchanger; a liquid cooling circuit in fluid communication with the refrigerant circuit, the liquid cooling circuit including at least one second heat exchanger and at least one pump; a valve assembly configured to selectively flow refrigerant to at least one of the air cooling circuit and the liquid cooling circuit; and a controller communicatively coupled to the valve assembly, the controller including one or more processors configured to control a flow of the refrigerant selectively to the at least one first heat exchanger, the at least one second heat exchanger, or both of the at least one first heat exchanger and the at least one second heat exchanger.

In one or more embodiments, a liquid cooling sub-system for a legacy air-cooling system is disclosed. In embodiments, the liquid cooling sub-system includes a first heat exchanger, the liquid cooling sub-system including: a second heat exchanger configured to transfer from a liquid to a refrigerant; and a set of valves configured to control a flow of the refrigerant to the first heat exchanger and the second heat exchanger.

In one or more embodiments, a method for controlling a hybrid air/liquid cooling unit is disclosed. In embodments, the method includes: providing a cabinet defining an interior space, a refrigerant circuit contained in the interior space, an air cooling circuit contained in the interior space and in fluid communication with the refrigerant circuit, the air cooling circuit including at least one first heat exchanger, a liquid cooling circuit contained in the interior space and in fluid communication with the refrigerant circuit, the liquid cooling circuit including at least one second heat exchanger and at least one pump, and a valve assembly contained in the interior space and configured to selectively flowing refrigerant to at least one of the air cooling circuit and the liquid cooling circuit; providing a controller communicatively coupled to the valve assembly the controller including one or more processors; closing one or more first heat exchanger valves of the valve assembly, wherein closing one or more first heat exchanger valves prevent a flow of refrigerant through the first heat exchanger, wherein the first heat exchanger includes an evaporator coil; and opening one or more second heat exchanger valves of the valve assembly, wherein opening one or more second heat exchanger valves enables the flow of refrigerant through the second heat exchanger, wherein the second heat exchanger includes a braze plate heat exchanger (BPHE).

According to another embodiment, disclosed herein is a cooling system including a refrigerant circuit, an air cooling circuit in fluid communication with the refrigerant circuit, the air cooling circuit including at least one first heat exchanger and at least one fan configured to flow air over the at least one first exchanger, a liquid cooling circuit in fluid communication with the refrigerant circuit, the liquid cooling circuit including at least one second heat exchanger and at least one pump, a valve assembly configured to selectively flow refrigerant to at least one of the air cooling circuit and the liquid cooling circuit, and a controller communicatively coupled to the valve assembly and the at least one fan. In embodiments, the controller includes one or more processors configured to operate the cooling system in a first operating mode in which the air cooling circuit is operative and the liquid cooling circuit is inoperative, and operate the cooling system in a second operating mode in which the air cooling circuit is inoperative, the liquid cooling circuit is operative, and the at least one fan is selectively operative to cool at least a portion of the cooling system.

According to another embodiment, disclosed herein is a hybrid air/liquid cooling unit including a cabinet defining an interior space, a refrigerant circuit contained in the interior space, an air cooling circuit contained in the interior space and in fluid communication with the refrigerant circuit, the air cooling circuit including at least one first heat exchanger and at least one fan configured to flow air over the at least one first exchanger, a liquid cooling circuit contained in the interior space and in fluid communication with the refrigerant circuit, the liquid cooling circuit including at least one second heat exchanger and at least one pump, a valve assembly contained in the interior space and configured to selectively flowing refrigerant to at least one of the air cooling circuit and the liquid cooling circuit, and a controller communicatively coupled to the valve assembly and the at least one fan, the controller including one or more processors. In embodiments, the controller is configured to operate the hybrid air/liquid cooling unit in a first operating mode in which the air cooling circuit is operative and the liquid cooling circuit is inoperative, and operate the hybrid air/liquid cooling unit in a second operating mode in which the air cooling circuit is inoperative, the liquid cooling circuit is operative, and the at least one fan is selectively operative to exhaust air from the interior space.

According to a further embodiment, disclosed herein is a method for controlling a hybrid air/liquid cooling unit including providing a cabinet defining an interior space, a refrigerant circuit contained in the interior space, an air cooling circuit contained in the interior space and in fluid communication with the refrigerant circuit, the air cooling circuit including at least one first heat exchanger and at least one fan configured to flow air over the at least one first exchanger, a liquid cooling circuit contained in the interior space and in fluid communication with the refrigerant circuit, the liquid cooling circuit including at least one second heat exchanger and at least one pump, and a valve assembly contained in the interior space and configured to selectively flowing refrigerant to at least one of the air cooling circuit and the liquid cooling circuit. The method further includes providing a controller communicatively coupled to the valve assembly and the at least one fan, the controller including one or more processors. In embodiments, the method includes operating, by the controller, the hybrid air/liquid cooling unit in a first operating mode in which the air cooling circuit is operative and the liquid cooling circuit is inoperative, and operating, by the controller, the hybrid air/liquid cooling unit in a second operating mode in which the air cooling circuit is inoperative, the liquid cooling circuit is operative, and the at least one fan is selectively operative to exhaust air from the interior space.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims.
FIG. 1 illustrates a block diagram depicting a cooling system for hybrid cooling of electronic equipment, in accordance with one or more embodiments of the disclosure.
FIG. 2 illustrates a block diagram depicting a cooling system for hybrid cooling of electronic equipment that includes a controller, in accordance with one or more embodiments of the disclosure.
FIG. 3 illustrates a block diagram depicting a cooling system for hybrid cooling of electronic equipment, in accordance with one or more embodiments of the disclosure.
FIG. 4 illustrates a simplified schematic of a cooling system for hybrid cooling of electronic equipment, which includes a braze plate heat exchanger (BPHE), in accordance with one or more embodiments of the disclosure.
FIG. 5 illustrates a simplified schematic of a cooling system for hybrid cooling of electronic equipment operating with 100% of the cooling performed via air-cooled heat exchangers, in accordance with one or more embodiments of the disclosure.
FIG. 6 illustrates a simplified schematic of a cooling system for hybrid cooling of electronic equipment operating with 100% of the cooling performed via liquid-cooled heat exchangers, in accordance with one or more embodiments of the disclosure.
FIG. 7 illustrates a simplified schematic of a cooling system operating with cooling performed equally between the first one or more heat exchangers, in accordance with one or more embodiments of the disclosure.
FIG. 8 illustrates a simplified schematic of a cooling system that includes a set of cooling circuits, in accordance with one or more embodiments of the disclosure.
FIG. 9A illustrates a diagram depicting a side view of a form factor for housing a cooling system, in accordance with one or more embodiments of the disclosure.
FIG. 9B illustrates a process flow diagram depicting a method for switching a cooling system from cooling electronic equipment via the first heat exchanger to cooling electronic equipment via a second heat exchanger, in accordance with one or more embodiments of the disclosure.
FIG. 10A is a schematic diagram of a cooling system implemented as a hybrid air-liquid cooling unit, in accordance with an example embodiment of the present disclosure;
FIG. 10B is a schematic diagram of the hybrid air/liquid cooling unit illustrating air flow through the unit, in accordance with an example embodiment of the present disclosure; and
FIG. 11 is a flow diagram illustrating a method for managing internal temperature in a hybrid air/liquid cooling unit, in accordance with an example embodiment of the present disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Disclosed is a hybrid air/liquid cooling system. The hybrid air/liquid cooling system operates with two types of heat exchangers: a first heat exchanger configured as an evaporator coil typically used in air cooling systems, and a second heat exchanger used for liquid cooling, such as a braze plate heat exchanger (BPHE). The hybrid air/liquid cooling system is designed to provide cooling that is 100% air-cooled, 100% liquid-cooled, or a mixture of air cooling and liquid cooling (e.g., 50% air-cooled, 50% liquid-cooled). The hybrid air/liquid cooling system may be initially built as a complete, hybrid cooling system, or be built sequentially by installing and integrating a liquid cooling componentry (e.g., a liquid cooling subsystem) with a legacy air-cooling system. Because the liquid cooling aspects of the hybrid air/liquid cooling system can be added to a legacy air-cooling system, a hybrid air/liquid cooling system provides an operator with the flexibility to convert their cooling system gradually and precisely from air cooling to liquid cooling without the need to purchase and install a separate liquid cooling unit, facilitating a seamless transition from air cooling to liquid cooling.

Also disclosed is a hybrid air/liquid cooling system implemented as a unit housing cooling circuits, and a method for managing air temperature within the unit using internal fan control. In embodiments, the hybrid air/liquid cooling unit includes a first heat exchanger (e.g., evaporator coil) associated with an air cooling circuit, and a second heat exchanger (e.g., braze plate heat exchanger (BPHE)) associated with a liquid cooling circuit. The hybrid air/liquid cooling unit may operate to provide cooling that is 100% air cooled, 100% liquid cooled, or a mixture of air cooling and liquid cooling. When operating the liquid cooling circuit to provide liquid cooling, the internal fan/blower associated with the air cooling circuit may be cycled on an off to exhaust hot air from within the unit as needed, thereby maintaining an internal air temperature and obviating the need for a dedicated cabinet exhaust fan and corresponding venting.

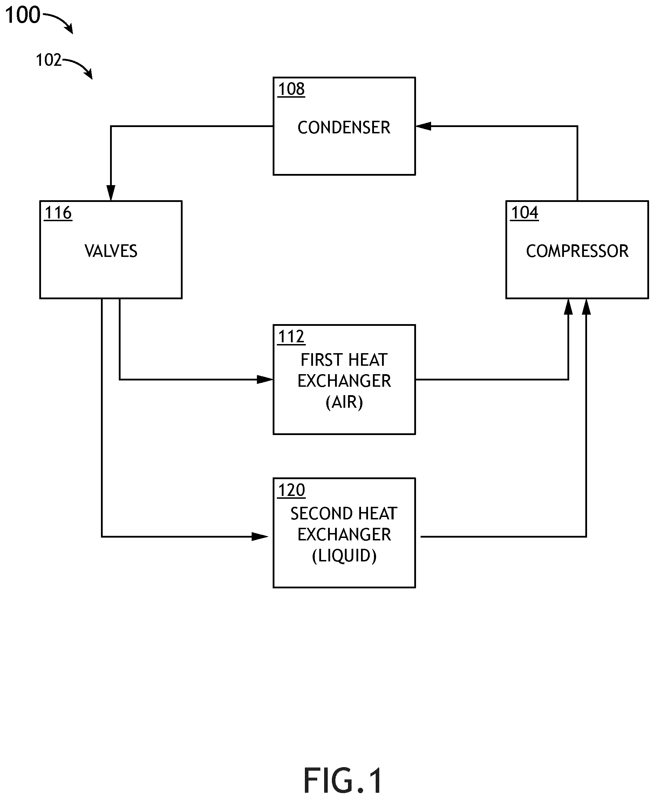

In embodiments, as illustrated in FIG. 1, a block diagram of a cooling system 100 for hybrid cooling of electronic equipment (e.g., a server or server farm/data center) is presented. The cooling system 100 may include one or more compressors 104 configured to pressurize a refrigerant (e.g., a gas refrigerant) within the cooling system 100. Pressurizing the refrigerant raises the temperature of the refrigerant higher than the ambient temperature of air outside of the cooling system 100. The cooling system 100 may use any type of refrigerant including, but not limited to, R22, R410A, R407C, R744, R134a, R1234yf, R290, R600a, R718. In some embodiments, the cooling system may include R454B refrigerant.

In embodiments, the cooling system 100 includes one or more cooling circuits 102 (e.g., refrigerant circuits) that include one or more condensers 108 containing one or more condenser coils. The one or more condensers 108 transfer heat from the refrigerant to an outside environment (e.g., outside of the cooling system 100). For example, the air (e.g., ambient temperature air) may be blown across the condenser coil by a fan. Heat is then transferred from the refrigerant (e.g., vapor refrigerant) to the air of the outside environment. This condenses the refrigerant into a liquid. The colder refrigerant then heads back to an evaporator coil to recollect heat. As used herein, a component of the cooling system 100 is also a component of the one or more cooling circuits 102, as the cooling system 100 comprises the one or more cooling circuits 102.

In embodiments, the cooling system 100 includes a first heat exchanger 112 configured to transfer heat from ambient air to the refrigerant. For example, the first heat exchanger 112 may include the aforementioned evaporator coil. When in use, heated air is blown across one or more evaporator coils of the first heat exchanger 112, causing the refrigerant to evaporate into a vapor/gas. This heat transfer cools the air, which is then returned to the electronic equipment to elicit the cooling effect.

In embodiments, the cooling system 100 includes a set of one or more valves 116 (e.g., expansion valves). The one or more valves 116 facilitate control of the flow of the refrigerant selectively through the first heat exchanger 112 and a second heat exchanger 120 to the one or more compressors 104. The one or more valves 116 control one or more qualities of the refrigerant, such as the percentage of refrigerant flowing as a liquid or as a gas/vapor, and ensures that the refrigerant is in gas/vapor form before returning to the compressors 104, as liquids are incompressible and may damage the one or more compressors 104.

In embodiments, the cooling system 100 includes the second heat exchanger 120. The second heat exchanger 120 is configured to transfer heat from a secondary liquid (e.g., liquid from a secondary cooling system) to the refrigerant. For example, the second heat exchanger 120 may transfer heat from the secondary fluid, e.g., (typically water or propylene glycol) to the refrigerant. The second heat exchanger 120 may include, but not be limited to a brazed plate heat exchanger (BPHE). A BPHE uses both conduction and convection to transfer heat as the secondary fluid passes through the plates of the BPHE, without a need for a blower or fan. Within the one or more cooling circuits 102, the first heat exchanger 112 and the second heat exchanger 120 utilize the same refrigerant (e.g., a portion of the refrigerant that has flowed through the first heat exchanger 112 will also flow through the second heat exchanger 120). In embodiments, the cooling system 100 provides direct-to-chip liquid cooling via the second heat exchanger 120.

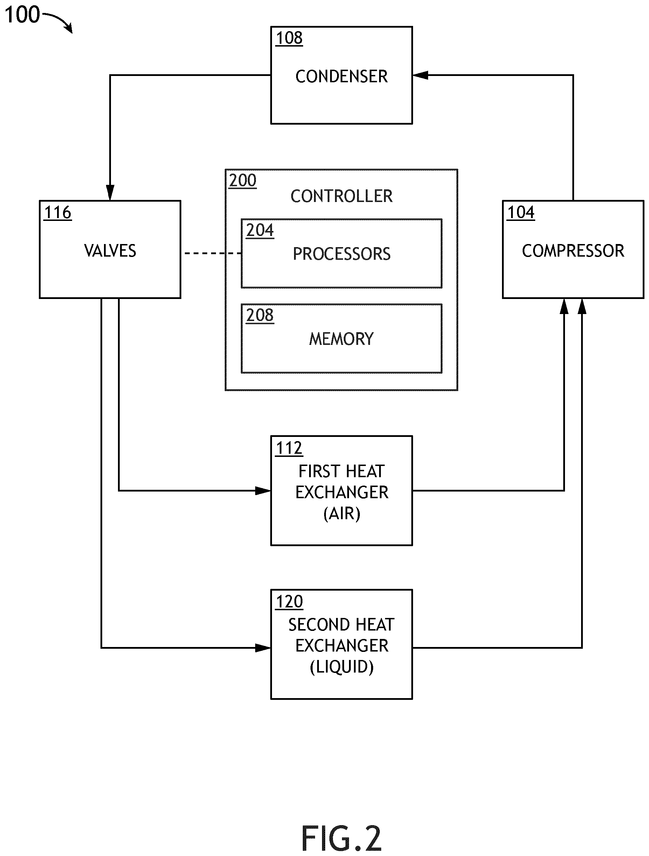

In embodiments, the cooling system 100 includes a controller 200 configured to control one or more processes within the cooling system 100, as shown in FIG. 2. For example, the controller 200 may control the action of the one or more valves 116 of the system. The controller 200 may control other aspects or components of the cooling system 100 including, but not limited to, the one or more compressors 104, and the one or more fans/blowers operating within the cooling system 100. The controller 200 may include one or more processors 204 and memory 208 that facilitate the controller 200 in controlling one or more functions of the cooling system 100. In embodiments, the one or more processors 204 are configured to receive instructions (e.g., from memory 208 or from an input from an operator via a user interface) to open or close one or more valves 116 of the set of valves, as described herein. In embodiments, the one or more processors 204 are configured to transmit a signal to the one or more valves 116 of the set of valves based on the instruction, as described herein.

In embodiments, the controller 200 may control other aspects or components of the cooling system 100 such as the one or more compressors 104 and the one or more fans/blowers operating within the cooling system 100 as discussed in detail below. In embodiments, the controller 200 includes one or more processors 204 and memory 208 that facilitate the controller 200 in controlling one or more functions of the cooling system 100. In embodiments, the one or more processors 204 are configured to receive instructions (e.g., from memory 208 or from an input from an operator via a user interface) to open or close one or more valves 116 and operate the one or more fans/blowers, as described herein. In embodiments, the one or more processors 204 are configured to transmit a signal to the one or more valves 116 and the one or more fans/blowers based on the instructions, as described herein.

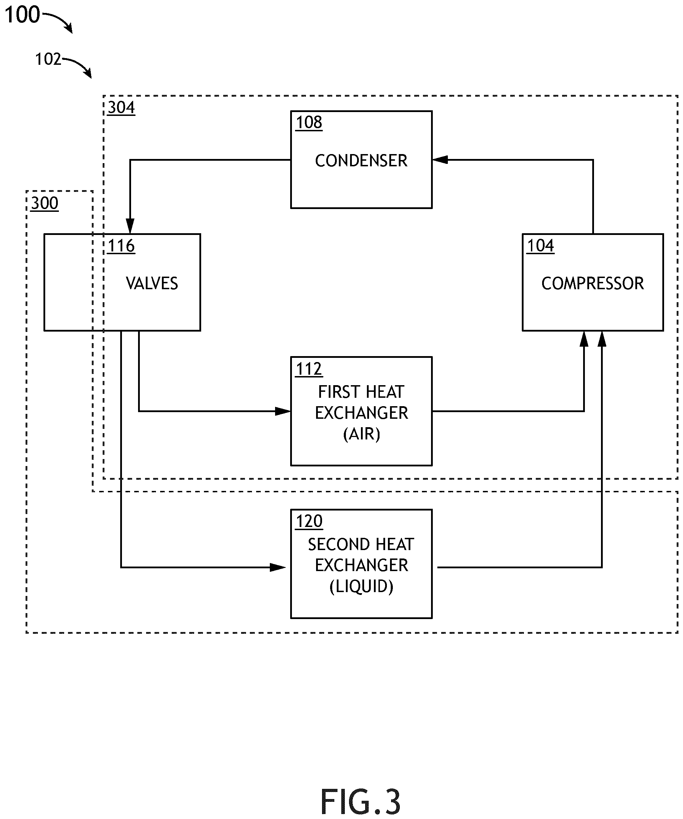

In embodiments, a liquid cooling sub-system 300 (e.g., liquid cooling circuit) is disclosed, in accordance with one or more embodiments of the disclosure, as shown in FIG. 3. In embodiments, the liquid cooling sub-system 300 includes the second heat exchanger 120 (e.g., the BPHE). The liquid cooling sub-system 300 may also include one or more valves 115 of the set of valves. In embodiments, the liquid cooling sub-system 300 is added to, or integrated with, another cooling system to form a hybrid cooling system 100. For example, the liquid cooling sub-system 300 can be added to, or integrated with, a legacy air-cooling system 304 (e.g., an air cooling circuit) For example, the liquid cooling sub-system 300 can be added to, or integrated with, an air-cooling subsystem that includes the first heat exchanger 112 and other componentry, such as a DP400 cooling system manufactured by the Vertiv company, to create a hybrid cooling system 100. Therefore, the cooling system 100 of this application may include the liquid cooling sub-system 300 that is integrated into a preexisting air-cooled subsystem or may include both the liquid cooling sub-system and a new or preexisting air-cooled subsystem.

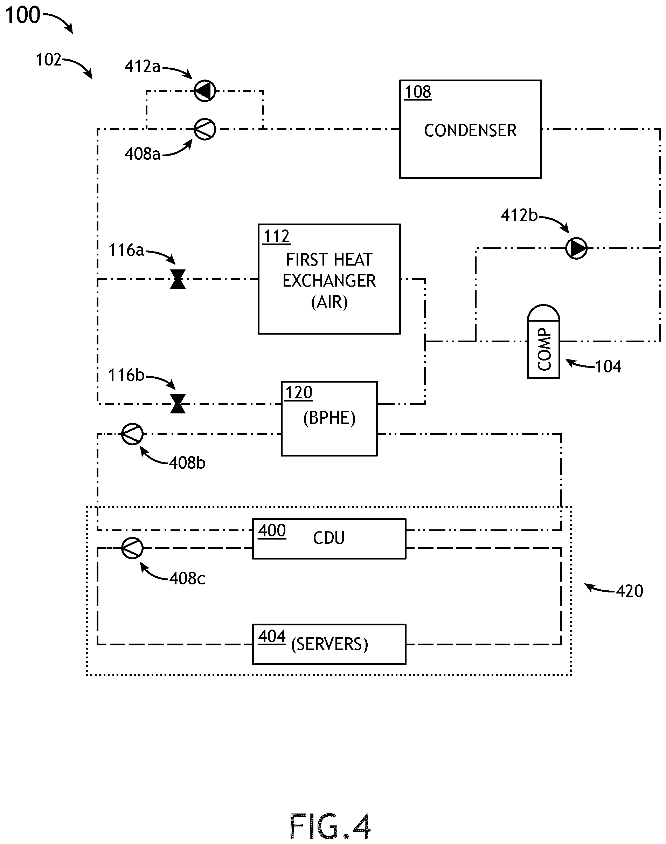

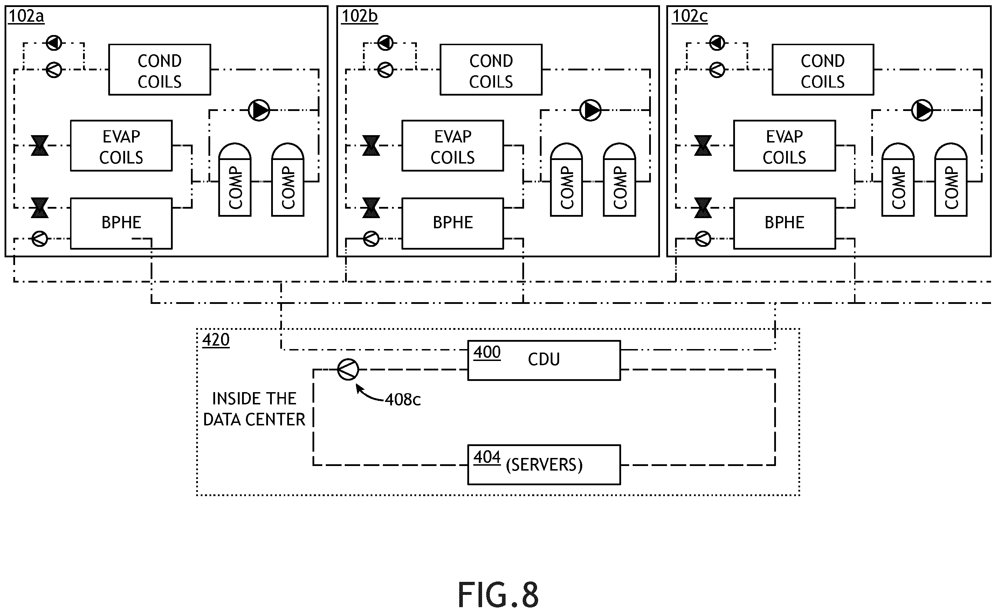

A detailed schematic view of the cooling system 100 is shown in FIG. 4, in accordance with one or more embodiments of the disclosure. In embodiments, with reference to FIG. 8, the cooling system 100 includes and/or is in fluid communication with, a cooling distribution unit (e.g., CDU 400). The CDU 400 receives chilled secondary fluid from the second heat exchanger 120 and circulates the chilled secondary fluid, or a chilled tertiary fluid (e.g., water or propylene glycol) that has exchanged heat with the secondary fluid via the CDU 400, to the electronic equipment 404 (e.g., servers). The electronic equipment 404 heats up the secondary fluid or tertiary fluid, and heat from these fluids is transferred back to the second heat exchanger 120 via circulation. In embodiments, the secondary fluid may also be circulated directly between the second heat exchanger 120 and the electronic equipment 404 (e.g., the CDU 400 being optional).

As shown in FIG. 4, the cooling system 100 may include a valve 116a, which controls the flow of refrigerant to the first heat exchanger 112, and a valve 116b, which controls the flow of refrigerant to the second heat exchanger 120. The cooling system 100 may also include one or more pumps 408a-c. For example, the cooling system 100 may include a pump 408a that facilitates the circulation of refrigerant. In another example, the cooling system 100 may include one or more pumps 408b-c configured to circulate secondary fluid through the second heat exchanger 120, the electronic equipment 404 (e.g., to computer chips within the servers) and/or the CDU 400. The cooling system 100 may also include one or more check valves 412a-b configured to prevent backflow of refrigerant. The one or more pumps 408a-c and one or more check valves 112a-b may be part of a complementary heating system that adds efficiency to the system 100. For example, one or more pumps 408a and check valves 412a-b may facilitate the circulation of refrigerant without the use of the one or more compressors 104. For instance, in times where the temperature outside is colder than the saturation temperature of the refrigerant, the system 100 may rely on the one or more pumps 408a and check valves 412a-b to circulate refrigerant in the absence of the compressor, reducing the power expended to circulate refrigerant. Because this aspect of cooling is complementary to compressor-mediated cooling, the one or more pumps 408a and one or more check valves 112a-b may be optional.

In embodiments, a portion of the cooling system 100 is physically located within a server environment 420 (e.g., the location of the servers or other electronic equipment 404 (data centers). For example, the CDU and the electronic equipment 404 being cooled may be located within the server environment 420. In another example, the CDU, the electronic equipment 404, and the second heat exchanger 120 may be located within the server environment. In another example, the electronic equipment 404 is within the server environment 420.

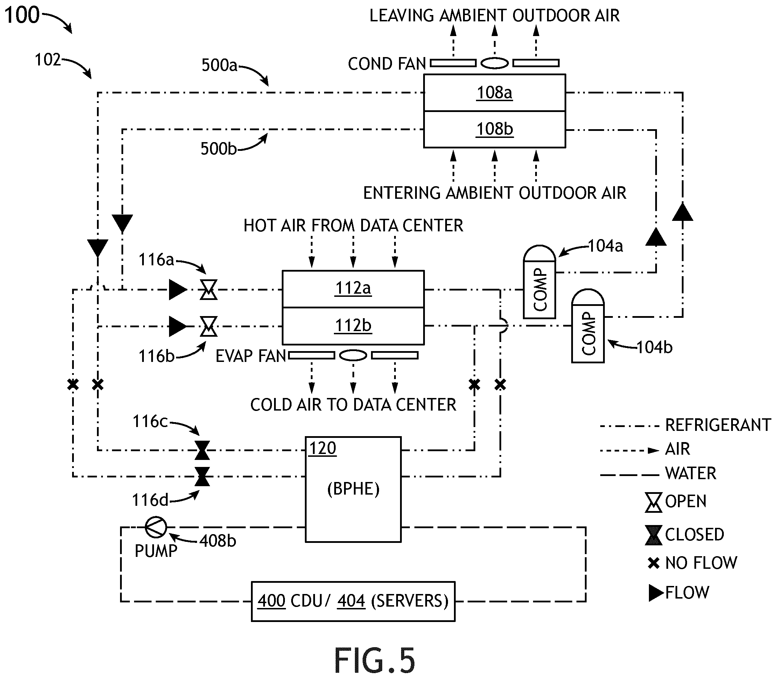

FIGS. 5-7 illustrate a more detailed schematic view of the cooling system 100 operating under different conditions. FIGS. 5-7 illustrate the cooling system 100 with one or more compressors 104a-b, one or more condensers 108a-b (e.g., multiple condenser coils), first one or more heat exchangers 112a-b (e.g., multiple evaporator coils), as well as multiple valves 116a-d (e.g., first heat exchanger valves 116a-b and second heat exchanger valves 116c-d). The cooling system 100 may include any number of compressors 104, condensers 108, one or more first heat exchangers 112a-b, and a second heat exchanger 120. The cooling system 100 may include multiple primary refrigerant circulation loops 500a-b. The system may also include one or more secondary cooling loops 502. For example, the one or more cooling circuits 102 of the cooling system 100 may include, or be in fluid communication with, two secondary cooling loops 502.

FIG. 5 illustrates the cooling system 100 operating with 100% of the cooling performed via the air-cooled first one or more heat exchangers 112a-b, in accordance with one or more embodiments of the disclosure. In this configuration, the first heat exchanger valves 116a-b are open (e.g., as indicated by the white valve icon), while the second heat exchanger valves 116c-d are closed (e.g., as indicated by the black valve icon), allowing refrigerant to circulate through the first one or more heat exchangers 112a-b, and preventing refrigerant from circulating through the second heat exchanger 120. Areas of circulation are denoted with an arrow in FIGS. 5-7, while areas of no flow are denoted by an "x".

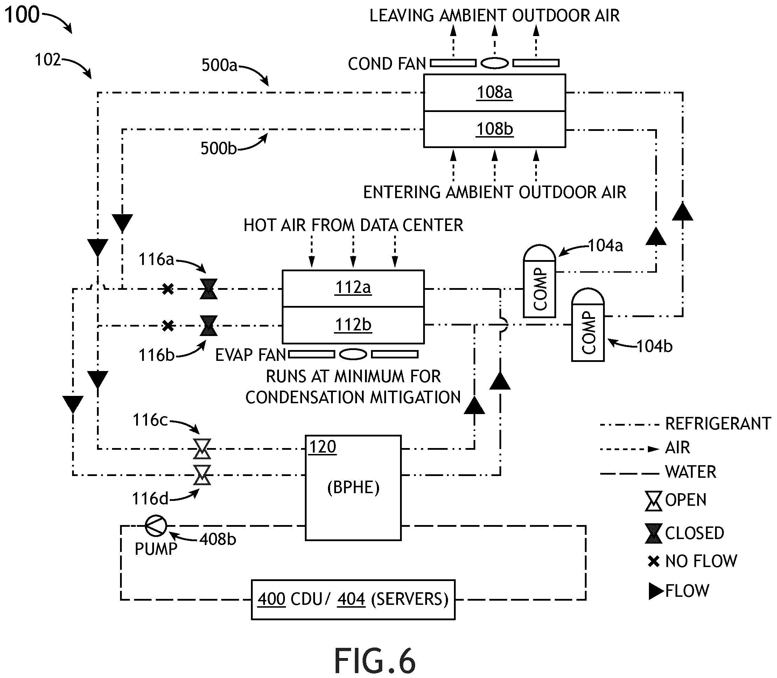

FIG. 6 illustrates the cooling system 100 operating with 100% of the cooling performed via the liquid-cooled second heat exchanger 120, in accordance with one or more embodiments of the disclosure. In this configuration, the first heat exchanger valves 116a-b are closed while the second heat exchanger valves 116c-d are open, allowing refrigerant to circulate through the second heat exchanger 120, and preventing refrigerant from circulating through the first one or more heat exchangers 112a-b. Areas of circulation are denoted with an arrow, while areas of no flow are denoted by an "x".

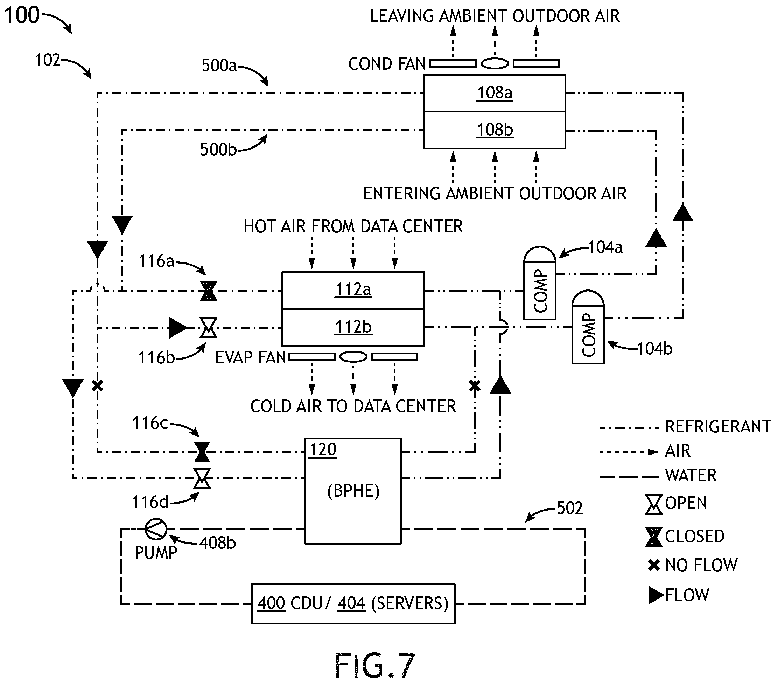

FIG. 7 illustrates the cooling system 100 operating with the cooling performed roughly equally between the first one or more heat exchangers 112a-b and the liquid-cooled second heat exchanger 120, in accordance with one or more embodiments of the disclosure. In this configuration, one of the first heat exchanger valves 116a is closed with the other first heat exchanger valve 116b is opened, while one of the second heat exchanger valves 116c is closed with the other second heat exchanger valve 116d opened, allowing refrigerant to be cooled by both air-cooling and liquid-cooling technologies. The cooling system 100 may be configured to allow any percentage of cooling to be performed by either the first one or more heat exchanger 112 or the second heat exchanger 120. For example, the ratio of percentages of cooling between the first one or more heat exchangers 112 and the second heat exchanger 120 may be 50% (air):50% (liquid). The switching of the valves 116a-d may be performed manually or via the controller 200.

In embodiments, the cooling system 100 includes one or more cooling circuits 102a-c, in accordance with one or more embodiments of the disclosure, and as shown in FIG. 8. The cooling system 100 may have any number of cooling circuits 102a-c including, but not limited to one cooling circuit 102, two cooling circuits 102, three cooling circuits 102, ten cooling circuits 102, 30 cooling circuits 102, or 100 or more cooling circuits 102. For example, the cooling system 100 may include up to 32 cooling circuits 102. The cooling circuits 102a-c may be in fluid communication with any number of CDUs 400 or electronic equipment 404 (e.g., servers) and may be organized in parallel with a set of CDUs 400 or electronic equipment 404. For example, the set of CDUs 400 and/or electronic equipment 404 may be paralleled together up to 32 cooling circuits.

In embodiments, one or more processors 204 are configured to receive instructions specific for each set of valves 116 (e.g., ON and OFF instructions) of the one or more cooling circuits 102. The one or more processors 204 may also be configured to transfer a signal to the valves 116 based on the instructions for each of the cooling circuits. For example, for a cooling system 100 with ten cooling circuits 102, the cooling system 100 may be instructed to, and be executed by the one or more processors 204 of the controller 200 to, operate the valves 116 so that three of the cooling circuits 102 operate with 100% air-cooling and seven of the cooling circuits 102 operate with 100% liquid-cooling. In this manner, the ratio of cooling between the first one or more heat exchangers 112 and the second heat exchanger 120 for the entire system 100 can be adjusted based on the opening and closing of valves 116 within each cooling circuit 102.

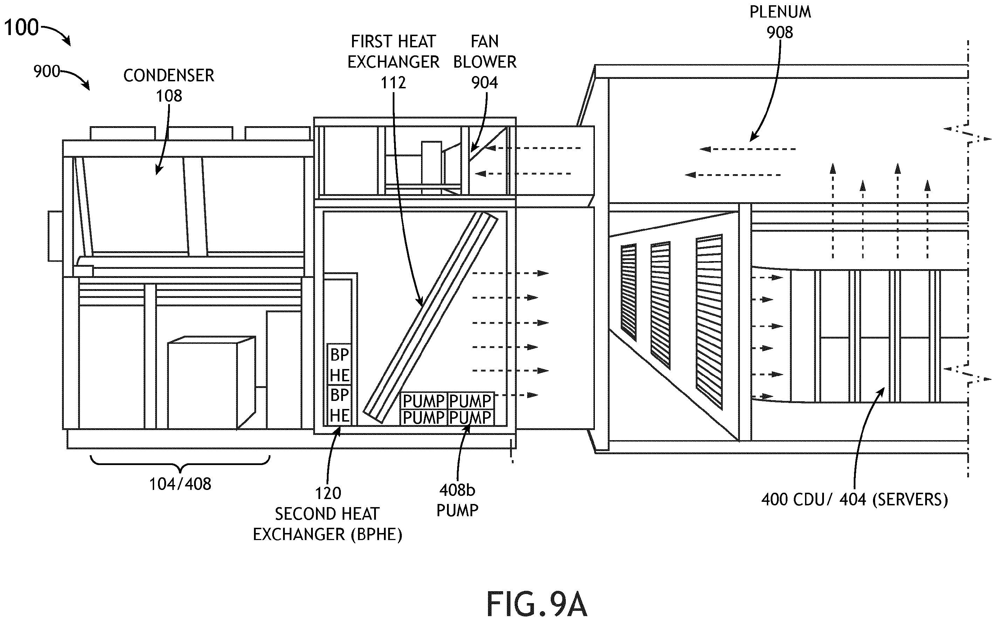

A form factor for housing the cooling system 100 is shown in FIG. 9A, in accordance with one or more embodiments of the disclosure. The coordinated cooling of refrigerant by the first heat exchanger 112 and the second heat exchanger 120 causes cooled air and/or cooled liquid to enter the electronic equipment 404 (with or without CDUs 400). Air may be circulated by one or more fans/blowers 904. Air that is heated by the electronic equipment 404 then rises into a plenum 908 and may be circulated back to the first heat exchanger 112 for another round of cooling. The cooling system 100 may be designed to fit into one or more form factors. For example, the cooling system 100 may be configured to have the same or similar width or height as the aforementioned DP400 cooling system.

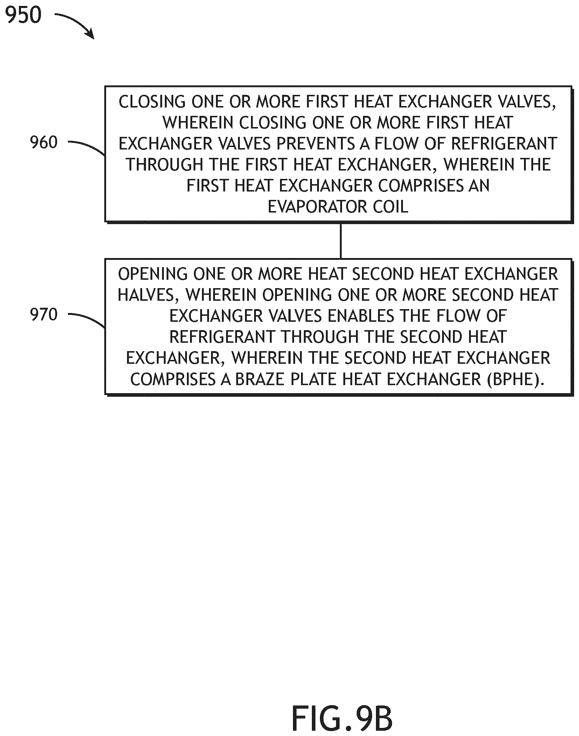

A method 950 for switching a cooling system 100 from cooling electronic equipment 404 via the first heat exchanger 112 to cooling electronic equipment 404 via a second heat exchanger 120 is disclosed, in accordance with one or more embodiments of the disclosure and as illustrated in FIG. 9B. One or more steps of the method 950 may be performed manually or via the one or more processors 204. The method 950 is further illustrated in FIGS. 5-6.

In embodiments, the method 950 includes a step 960 of closing one or more first heat exchanger valves 116a-b, wherein closing one or more first heat exchanger valves 116a-b prevents a flow of refrigerant through the first heat exchanger 112, wherein the first heat exchanger 112 comprises an evaporator coil. In embodiments, the method 950 includes a step 970 of opening one or more heat second heat exchanger valves 116c-d, wherein opening one or more second heat exchanger valves 116c-d enables the flow of refrigerant through the second heat exchanger 120, wherein the second heat exchanger 120 comprises a braze plate heat exchanger (BPHE).

In embodiments, method 950 further includes changing the amount of refrigerant (e.g., charge) in the cooling system 100. The amount of refrigerant in the system will vary whether the one or more cooling circuits 102 are operating as air-cooled or liquid-cooled. This is because the amount of refrigerant in the first heat exchanger 112 (e.g., an evaporator coil) is likely larger than the amount of charge in the second heat exchanger 120 (e.g., BPHE). In addition, the refrigerant migrates, and depending on when they shut down the unit to transition, the refrigerant may migrate and sit in the first heat exchanger 112. This may require a technician to pull refrigerant out of the one or more cooling circuits 102 and then recharge the cooling system 100 to a newly calculated amount. This issue may be solved with a receiver that can hold an extra refrigerant charge.

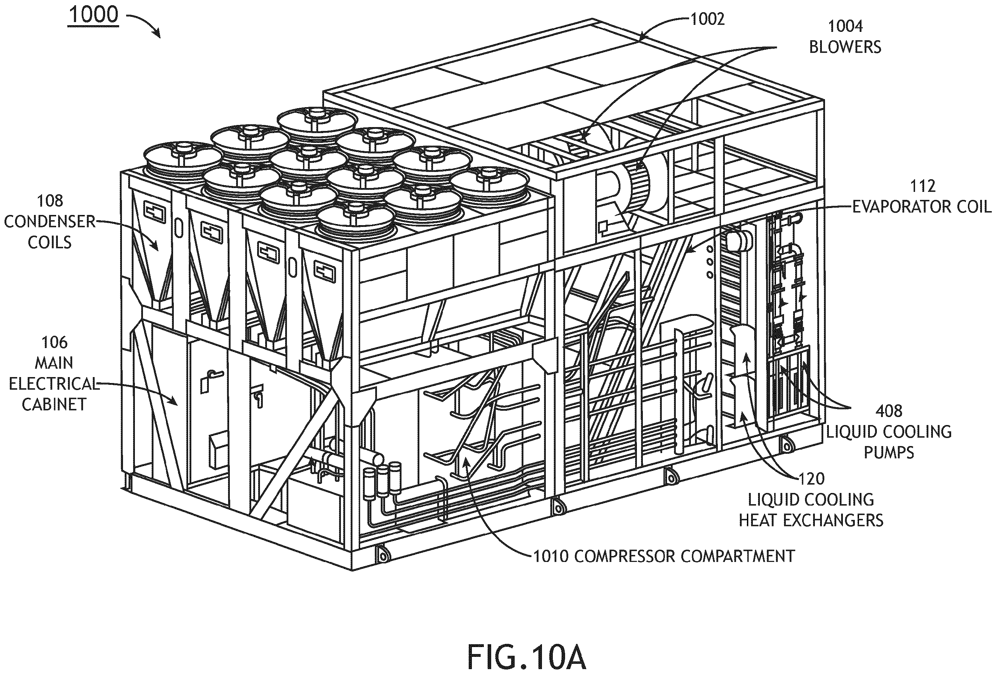

FIG. 10A is a schematic illustration of the cooling system 100 implemented as a hybrid air/liquid unit 1000. In embodiments, the hybrid air/liquid unit 1000 may be self-contained and positioned in relation to electronic equipment housed in a data center. In embodiments, the hybrid air/liquid unit 1000 includes one or more cabinets 1002 defining interior space(s) for containing system components. For example, the condensers 108 may be disposed in a first portion of the unit 1000, electrical components may be disposed in a main electrical cabinet 1006 of the unit 1000, the compressors may be disposed in a compressor compartment 1010 of the unit 1000, the one or more first heat exchangers 112 may be disposed in another portion of the unit 1000, the one or more second heat exchangers 120 may be disposed in yet another portion of the unit 1000, and the pumps 408 associated with the liquid cooling circuit disposed proximal to the one or more second heat exchangers 120. In embodiments, one or more of the interior spaces may be confined spaces. In embodiments, one or more fans 1004 (e.g., blowers) are disposed within the unit and are associated with the air cooling circuit. In use, the one or more fans 1004 operate to circulate air through the unit 1000 and flow air over the one or more first exchangers 112, as discussed below.

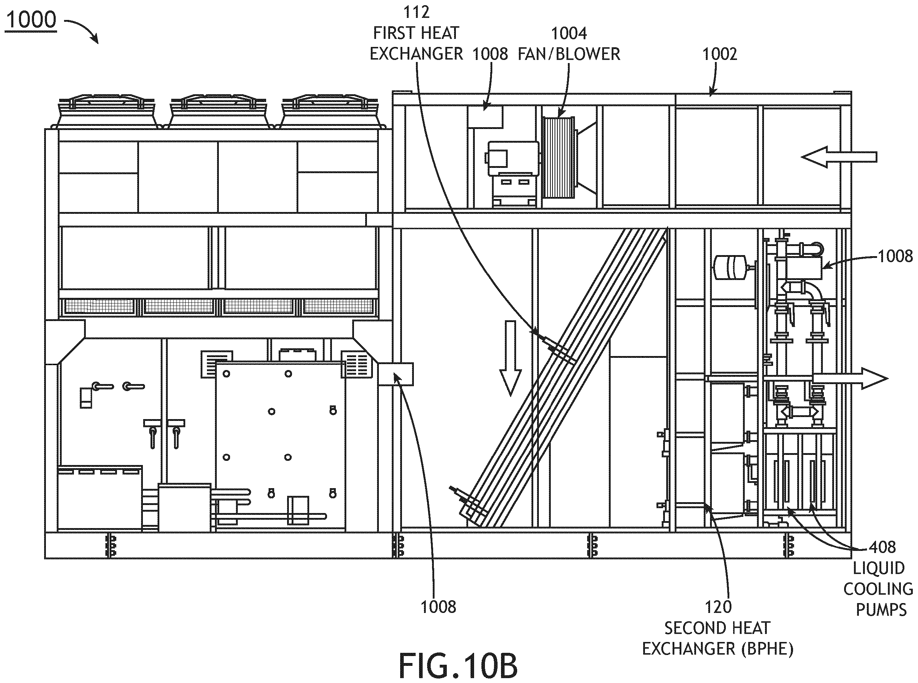

FIG. 10B illustrates air flow through the hybrid air/liquid unit 1000 via the action of the one or more fans 1004. In embodiments, hot air is drawn in through the upper portion of the unit when the one or more fans 1004 are powered on. The hot air, drawn into the unit by the one or more fans 1004, is directed to flow over the one or more first heat exchangers 112 associated with the air cooling circuit whereby heat is absorbed by the refrigerant and the produced cold air is directed out through another portion of the unit, for instance a lower portion of the unit toward the electronic equipment. When the cooling system 100 is operating in the first operating mode for air cooling, the one or more fans are powered on and may run continuously to circulate air through the unit 1000 as shown.

In a traditional hybrid system operating in a liquid cooling mode, the one or more fans 1004 associated with the air cooling circuit would typically be powered off According to the present disclosure, when operating the cooling system 100 in the second operating mode for liquid cooling, the one or more fans 1004 associated with the air cooling circuit may be cycled on and off as needed to exhaust hot air from within the unit. More specifically, when operating in the second operating mode in which the air cooling circuit is inoperative, liquid cooling is achieved by the second heat exchanger 120 associated with the liquid cooling circuit. When the liquid cooling circuit is operative, the one or more pumps 408 associated with the liquid cooling circuit are powered on to circulate the liquid medium to the electronic equipment and/or the CDU 400. When the pumps are powered on, the electric motors associated with the pumps generate heat. The heat generated by the electric motors, because of the disposition of the pumps 408 and motors within the unit 1000, and in some cases within a confined space, causes the air temperature within the unit to rise. Over time, heat may build up within the unit to a temperature that may cause damage to the system components, such as the electrical components housed within the unit 1000. In that case, it may be necessary to "flush" the hot air from inside the unit 1000 to maintain an acceptable air temperature within the unit 900.

In embodiments, the unit 1000 may include one or more temperature sensors 1008 configured to sense the air temperature within the unit 1000. The one or more temperature sensors 1008 may be positioned within the unit 1000 in predetermined areas, for instance proximal to the pumps 408, the one or more first heat exchangers 112, the one or more fans 1004, electronic components, etc. In use, the one or more temperature sensors 1008 output internal temperature data to the controller 200, whereby the temperature data is received by the controller 200 and used to cycle on and off the one or more fans 1004 as needed to exhaust the hot air within the unit 1000.

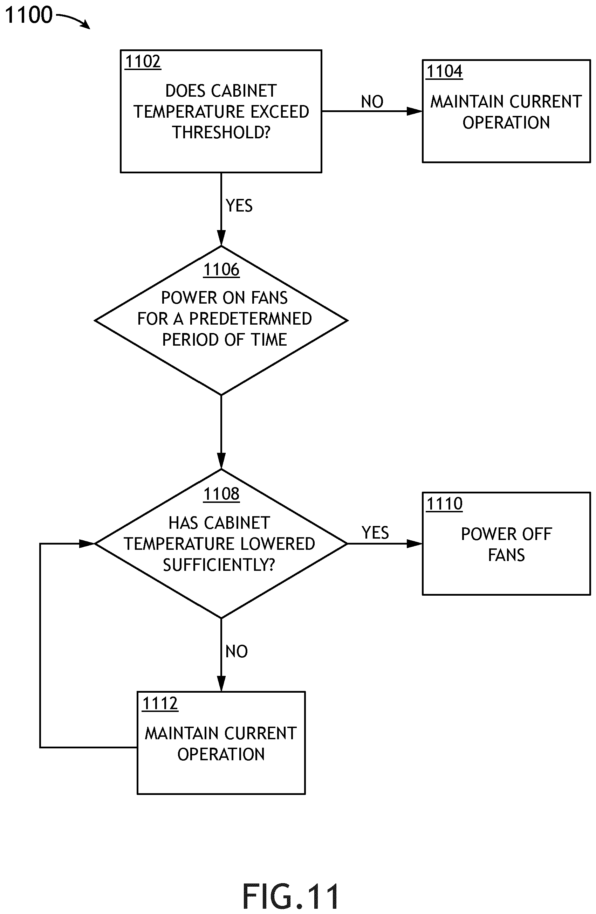

FIG. 11 illustrates a temperature control scheme/methodology 1100 for managing unit temperature. In a step 1102, the controller 200 is configured to determine, from data received from the one or more temperature sensors 1008, if the internal air temperature in the unit exceeds a predefined threshold air temperature while the cooling system 100 is operating in the second operating mode corresponding to liquid cooling. In a step 1104, if the internal air temperature is determined to be below the predefined threshold temperature, the second operating mode is maintained without powering one the one or more fans 1004 associated with the air cooling circuit. In a step 1106, if the internal air temperature is determined to exceed the threshold temperature, the one or more fans 1004 are powered on for a predetermined time period to (e.g., ten minutes) exhaust the air within the unit 1000.

In embodiments, the one or more fans 1004 within the unit may be the type having sensitive contacts susceptible to damage from repeated cycling on and off and short duration operation. As such, the time period in which the one or more fans 1004 are powered on may be several continuous minutes to ensure the hot air within the unit has been exhausted and the air temperature returned to a safe operating temperature. For example, the predefined time period may be 5 minutes, 10 minutes, 15 minutes, etc. In embodiments, in the case of variable speed one or more fans 1004, the one or more fans 1004 may be run at low or minimum speed during the second operating mode corresponding to liquid cooling such that a minimal volume of hot air is directed toward the electronic equipment to be cooled by the liquid cooling circuit. In other words, considering the hot air is exhausted through the outlet corresponding to the air cooling circuit, it is preferable to minimize the air flow volume during the unit cooling operating mode.

Continuing with the method 1100, in a step 1108, the controller 200 determines from the one or more sensors 1008 if the air temperature within the unit 1000 has decreased below the predefined threshold temperature, and in some embodiments to a predefined amount below the predefined threshold temperature. In the step 1108, the temperature determination may be made while the one or more fans 1004 are running, for instance near the end of the predefined time period (e.g., minute 8 or 9 in the case of a 10 minute time period). In a step 1110, if it is determined that the air temperature in the unit 1000 has decreased to below the predefined temperature threshold, the one or more fans 1004 may be powered off at the end of the predefined time period. In a step 1112, if it is determined that the air temperature in the unit 1000 has not sufficiently decreased to below the predefined threshold temperature, then the one or more fans 1004 may continue to run consecutively for another predefined time period to avoid having to power off and then power on the one or more fans 1004 twice.

The one or more processors 204 may be implemented as any suitable processor(s), such as at least one general purpose processor, at least one central processing unit (CPU), at least one image processor, at least one graphics processing unit (GPU), at least one field-programmable gate array (FPGA), and/or at least one special purpose processor configured to execute instructions for performing (e.g., collectively performing if more than one processor) any or all of the operations disclosed throughout.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application-specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

As used throughout and as would be appreciated by those skilled in the art, "at least one non-transitory computer-readable medium" or "memory 208" may refer to as at least one non-transitory computer-readable medium (e.g., e.g., at least one computer-readable medium implemented as hardware; e.g., at least one non-transitory processor-readable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true scope of the subject matter described herein. Furthermore, it is to be understood that the invention is defined by the appended claims.
The disclosure comprises the following items:
1. A cooling system comprising:
   a refrigerant circuit;
   an air cooling circuit in fluid communication with the refrigerant circuit, the air cooling circuit including at least one first heat exchanger;
   a liquid cooling circuit in fluid communication with the refrigerant circuit, the liquid cooling circuit including at least one second heat exchanger and at least one pump;
   a valve assembly configured to selectively flow refrigerant to at least one of the air cooling circuit and the liquid cooling circuit; and
   a controller communicatively coupled to the valve assembly, the controller including one or more processors configured to control a flow of the refrigerant selectively to the at least one first heat exchanger, the at least one second heat exchanger, or both of the at least one first heat exchanger and the at least one second heat exchanger.
2. The cooling system of item 1, wherein the second heat exchanger comprises a braze plate heat exchanger (BPHE).
3. The cooling system of item 1 or item 2, further comprising at least one cooling distribution unit in fluid communication with the second heat exchanger, wherein the pump is configured to circulate a secondary fluid between the second heat exchanger and the cooling distribution unit.
4. The cooling system of any preceding item, wherein the second heat exchanger is configured to provide direct-to-chip liquid cooling.
5. The cooling system of any preceding item, wherein the air cooling circuit comprises at least one fan communicatively coupled to the controller and configured to flow air over the at least one first exchanger.
6. The cooling system of any preceding item, wherein the one or more processors are further configured to:
   operate the cooling system in a first operating mode in which the air cooling circuit is operative and the liquid cooling circuit is inoperative; and
   operate the cooling system in a second operating mode in which the air cooling circuit is inoperative, the liquid cooling circuit is operative, and the at least one fan is selectively operative to cool at least a portion of the cooling system.
7. The cooling system of any preceding item, further comprising:
   at least one cabinet containing at least a portion of each of the refrigerant circuit, the air cooling circuit, the liquid cooling circuit, and the valve assembly; and
   at least one temperature sensor disposed in the at least one cabinet, the at least one temperature sensor configured to sense an internal air temperature in the at least one cabinet;
   wherein the controller is communicatively coupled to the at least one temperature sensor, and is further configured to:
      when the cooling system is operating in the second operating mode, power on the at least one fan when the internal air temperature in the at least one cabinet exceeds a predefined threshold air temperature.
8. The cooling system of any preceding item, wherein the at least one fan is powered on for a predefined time period.
9. The cooling system of any preceding item, wherein the controller is further configured to:
   when the at least one fan is powered on for the predefined time period, determine from the at least one temperature sensor if the internal air temperature in the at least one cabinet has decreased to below the predefined threshold air temperature;
   if the internal air temperature in the at least one cabinet is determined to have decreased to below the predefined threshold air temperature, power off the at least one fan; and
   if the internal air temperature in the at least one cabinet is determined not to have decreased below the predefined threshold air temperature, maintain the at least one fan powered on for another consecutive predefined time period.
10. The cooling system of any preceding item, wherein the at least one first heat exchanger comprises an evaporator coil.
11. A liquid cooling sub-system for a legacy air-cooling system comprising a first heat exchanger, the liquid cooling sub-system comprising:
   a second heat exchanger configured to transfer from a liquid to a refrigerant; and
   a set of valves configured to control a flow of the refrigerant to the first heat exchanger and the second heat exchanger.
12. The liquid cooling sub-system of item 11, wherein the first heat exchanger comprises an evaporator coil.
13. The liquid cooling sub-system of any of items 11-12, wherein the second heat exchanger comprises a braze plate heat exchanger (BPHE).
14. The liquid cooling sub-system of any of items 11-13, further comprising at least one cooling distribution unit in fluid communication with the second heat exchanger.
15. The liquid cooling sub-system of any of items 11-14, further comprising a pump configured to circulate a secondary fluid between the second heat exchanger and the cooling distribution unit.
16. The liquid cooling sub-system of any of items 11-15, further comprising one or more processors configured to:
   receive an instruction to open or close one or more valves of the set of valves; and
   transmit a signal to the one or valves of the set of valves based on the instruction.
17. The liquid cooling sub-system of any of items 11-16, further comprising a plurality of cooling circuits, wherein the one or more processors are further configured to receive instructions specific for each set of valves for each cooling circuit of the plurality of cooling circuits.
18. The liquid cooling sub-system of any of items 11-17 wherein the second heat exchanger is configured to provide direct-to-chip liquid cooling.
19. A method for controlling a hybrid air/liquid cooling unit, the method comprising:
   providing a cabinet defining an interior space, a refrigerant circuit contained in the interior space, an air cooling circuit contained in the interior space and in fluid communication with the refrigerant circuit, the air cooling circuit including at least one first heat exchanger, a liquid cooling circuit contained in the interior space and in fluid communication with the refrigerant circuit, the liquid cooling circuit including at least one second heat exchanger and at least one pump, and a valve assembly contained in the interior space and configured to selectively flowing refrigerant to at least one of the air cooling circuit and the liquid cooling circuit;
   providing a controller communicatively coupled to the valve assembly the controller including one or more processors;
   closing one or more first heat exchanger valves of the valve assembly, wherein closing one or more first heat exchanger valves prevent a flow of refrigerant through the first heat exchanger, wherein the first heat exchanger comprises an evaporator coil; and opening one or more second heat exchanger valves of the valve assembly, wherein opening one or more second heat exchanger valves enables the flow of refrigerant through the second heat exchanger, wherein the second heat exchanger comprises a braze plate heat exchanger (BPHE).
20. The method of item 19, wherein the air cooling circuit comprises at least one fan communicatively coupled to the controller, wherein the fan is configured to configured to flow air over the at least one first exchanger.

## Claims

1. A cooling system comprising:
a refrigerant circuit;
an air cooling circuit in fluid communication with the refrigerant circuit, the air cooling circuit including at least one first heat exchanger;
a liquid cooling circuit in fluid communication with the refrigerant circuit, the liquid cooling circuit including at least one second heat exchanger and at least one pump;
a valve assembly configured to selectively flow refrigerant to at least one of the air cooling circuit and the liquid cooling circuit; and
a controller communicatively coupled to the valve assembly, the controller including one or more processors configured to control a flow of the refrigerant selectively to the at least one first heat exchanger, the at least one second heat exchanger, or both of the at least one first heat exchanger and the at least one second heat exchanger.

2. The cooling system of claim 1, wherein the second heat exchanger comprises a braze plate heat exchanger, BPHE.

3. The cooling system of claim 1 or claim 2, further comprising at least one cooling distribution unit in fluid communication with the second heat exchanger, wherein the pump is configured to circulate a secondary fluid between the second heat exchanger and the cooling distribution unit.

4. The cooling system of any preceding claim, wherein the second heat exchanger is configured to provide direct-to-chip liquid cooling.

5. The cooling system of any preceding claim, wherein the air cooling circuit comprises at least one fan communicatively coupled to the controller and configured to flow air over the at least one first exchanger.

6. The cooling system of claim 5, wherein the one or more processors are further configured to:
operate the cooling system in a first operating mode in which the air cooling circuit is operative and the liquid cooling circuit is inoperative; and
operate the cooling system in a second operating mode in which the air cooling circuit is inoperative, the liquid cooling circuit is operative, and the at least one fan is selectively operative to cool at least a portion of the cooling system.

7. The cooling system of claim 6, further comprising:
at least one cabinet containing at least a portion of each of the refrigerant circuit, the air cooling circuit, the liquid cooling circuit, and the valve assembly; and
at least one temperature sensor disposed in the at least one cabinet, the at least one temperature sensor configured to sense an internal air temperature in the at least one cabinet;
wherein the controller is communicatively coupled to the at least one temperature sensor, and is further configured to:
when the cooling system is operating in the second operating mode, power on the at least one fan when the internal air temperature in the at least one cabinet exceeds a predefined threshold air temperature.

8. The cooling system of claim 7, wherein the at least one fan is powered on for a predefined time period.

9. The cooling system of claim 8, wherein the controller is further configured to:
when the at least one fan is powered on for the predefined time period, determine from the at least one temperature sensor if the internal air temperature in the at least one cabinet has decreased to below the predefined threshold air temperature;
if the internal air temperature in the at least one cabinet is determined to have decreased to below the predefined threshold air temperature, power off the at least one fan; and
if the internal air temperature in the at least one cabinet is determined not to have decreased below the predefined threshold air temperature, maintain the at least one fan powered on for another consecutive predefined time period.

10. The cooling system of any preceding claim, wherein the at least one first heat exchanger comprises an evaporator coil.

11. A method for controlling a hybrid air/liquid cooling unit, the method comprising:
providing a cabinet defining an interior space, a refrigerant circuit contained in the interior space, an air cooling circuit contained in the interior space and in fluid communication with the refrigerant circuit, the air cooling circuit including at least one first heat exchanger, a liquid cooling circuit contained in the interior space and in fluid communication with the refrigerant circuit, the liquid cooling circuit including at least one second heat exchanger and at least one pump, and a valve assembly contained in the interior space and configured to selectively flowing refrigerant to at least one of the air cooling circuit and the liquid cooling circuit;
providing a controller communicatively coupled to the valve assembly the controller including one or more processors;
closing one or more first heat exchanger valves of the valve assembly, wherein closing one or more first heat exchanger valves prevent a flow of refrigerant through the first heat exchanger; and
opening one or more second heat exchanger valves of the valve assembly, wherein opening one or more second heat exchanger valves enables the flow of refrigerant through the second heat exchanger.

12. The method of claim 11, wherein the first heat exchanger comprises an evaporator coil.

13. The method of claim 11 or claim 12, wherein the second heat exchanger comprises a braze plate heat exchanger, BPHE.

14. The method of any of claims 11-13, wherein the air cooling circuit comprises at least one fan communicatively coupled to the controller, wherein the fan is configured to configured to flow air over the at least one first exchanger.
